# EUROPEAN PATENT APPLICATION

(11) **EP 4 645 082 A1**
(43) Date of publication of application: **05.11.2025**
(21) Application number: 25172416.7
(22) Date of filing: 24.04.2025
(51) Int. Cl.: G06F 9/48, G06F 9/52, G06F 11/362

(54) **EFFICIENT MULTITHREADED QUANTUM-BASED SCHEDULER WITH TIME SIMULATION**

(30) Priority: 30.04.2024 US 202418650940
(71) Applicant: Microsoft Technology Licensing, LLC, Redmond, WA 98052 (US)
(72) Inventor: PATIL, KIRAN ANANDA, Redmond, 98052 (US); SRIVASTAVA, NISHEETH, Redmond, 98052 (US); SZREDER, PIOTR WOJCIECH, Redmond, 98052 (US)
(74) Representative: CMS Cameron McKenna Nabarro Olswang LLP

(57) **Abstract**

Systems and methods are provided for implementing efficient multithreaded quantum-based scheduler with time simulation. In response to a virtual platform simulator using a quantum-based scheduler to grant a first quantum of time to each of a plurality of simulated threads during a simulation session, each simulated thread reports its waiting status (e.g., waiting for additional quantum grants of time or waiting for an event signal from another simulated thread) to the quantum-based scheduler, at a sub-quantum level. The quantum-based scheduler is thus kept updated on a sub-quantum level, and thus is able to keep a sub-quantum count of active simulated threads as well as a sub-quantum count of simulated threads waiting for additional quantum grants of time and/or a sub-quantum count of simulated threads waiting for event signals. The quantum-based scheduler may also enable automatic detection of potential deadlock conditions (e.g., where each simulated thread is waiting for event signals).

## Description

### BACKGROUND

As computing processes become more and more complex, simulating execution of corresponding software on hardware components become more and more useful for identifying potential errors and for debugging during software development or other operations (e.g., validation operations or artificial intelligence ("AI") system operations). It is with respect to this general technical environment to which aspects of the present disclosure are directed. In addition, although relatively specific problems have been discussed, it should be understood that the examples should not be limited to solving the specific problems identified in the background.

### SUMMARY

This summary is provided to introduce a selection of concepts in a simplified form that are further described below in the detailed description section. This summary is not intended to identify key features or essential features of the claimed subject matter, nor is it intended as an aid in determining the scope of the claimed subject matter.

The currently disclosed technology, among other things, provides for efficient multithreaded quantum-based scheduler with time simulation. A virtual platform simulator uses a quantum-based scheduler to grant a first quantum of time to each of a plurality of simulated threads during a simulation session. During the first quantum of time, the plurality of simulated threads concurrently performs a corresponding plurality of assigned simulation tasks. During the granted first quantum of time, the quantum-based scheduler receives a function call or message from each waiting simulated thread among the plurality of simulated threads, the function call or message indicating that the waiting simulated thread is either waiting on an additional quantum grant of time to perform its current assigned simulation task or waiting for an event signal from another simulated thread among the plurality of simulated threads. In response to receiving the function call or message from each waiting simulated thread, the quantum-based scheduler decreases a counter of active simulated threads based on a number of waiting simulated threads sending the function call or message. If there are no more active simulated threads and if at least one simulated thread is waiting on an additional quantum grant of time to perform its current assigned simulation task, the quantum-based scheduler grants a second quantum of time to each of a plurality of simulated threads. If there are no more active simulated threads and if each simulated thread in the plurality of simulated threads is waiting on event signals from other simulated threads, the quantum-based scheduler ends the simulation session and performs an end of simulation task.

The details of one or more aspects are set forth in the accompanying drawings and description below. Other features and advantages will be apparent from a reading of the following detailed description and a review of the associated drawings. It is to be understood that the following detailed description is explanatory only and is not restrictive of the invention as claimed.

### BRIEF DESCRIPTION OF THE DRAWINGS

A further understanding of the nature and advantages of particular embodiments may be realized by reference to the remaining portions of the specification and the drawings, which are incorporated in and constitute a part of this disclosure.
Fig. 1 depicts an example system for implementing efficient multithreaded quantum-based scheduler with time simulation.
Fig. 2 depicts an example sequence flow for multithreaded operation when implementing efficient multithreaded quantum-based scheduler with time simulation.
Fig. 3 depicts another example sequence flow for multithreaded operation when implementing efficient multithreaded quantum-based scheduler with time simulation.
Figs. 4A-4G depict various example methods for implementing efficient multithreaded quantum-based scheduler with time simulation.
Fig. 5 depicts a block diagram illustrating example physical components of a computing device with which aspects of the technology may be practiced.

### DETAILED DESCRIPTION OF CERTAIN EMBODIMENTS

Virtual platform simulators may be used for simulating execution of software on hardware components. One of the main challenges of designing virtual platform simulators is simulating parallel execution of its components. From a firmware perspective, especially for layers higher than a hardware abstraction layer ("HAL"), simulation speed and approximation of cycle performance are becoming crucial, however, these features are often something a single simulator cannot provide. Simulator designs targeting to provide proper cycle approximation are often based on sequential scheduling (e.g., SystemC^{™}, which is a set of C++ classes and macros that provide an event-driven simulation interface) that by design runs on a single host thread, which hinders performance. On the other hand, time-quantum based schedulers, by providing a possibility of parallel execution on multiple host threads, may result in indeterministic execution order of its components (e.g., threads) on a sub-quantum level. The selected quantum value is also a maximum accuracy of cycle approximation that can be achieved on the system level. A quantum scheduler allows all its components to run independently for a quantum of time. Synchronization between components for conventional quantum schedulers is only guaranteed on quantum borders or boundaries. Although providing a simulation performance advantage by running on multiple host threads, in the case of frequent (in comparison to quantum size) component synchronization, such conventional quantum schedulers may become inefficient with respect to simulated time approximation or simulation performance as it introduces unpredictable dependencies between components executing in parallel, at least from a scheduler perspective. As an example, a producer component that is scheduled to execute its quantum grant as a last component due to insufficient host threads would cause all the consumer components that are scheduled earlier to spend their entire quantum waiting. As synchronization can happen only on quantum border, a consumer component that needs to wait for an event can either spin-check for updates moving simulated time slowly forward or decide to skip execution until next quantum. The former (also referred to as "spinning") causes simulation performance degradation, while the latter (also referred to as "skipping") introduces a time approximation error of up to the size of a quantum of time.

The present technology, as described herein, provides a quantum-based scheduler that allows parallel execution, including efficient component synchronization handling, and that allows cycle performance approximation capabilities similar to those of a sequential scheduler. The quantum-based scheduler, unlike classical quantum schedulers, is configured to monitor the number of active threads at the sub-quantum level (not only at the quantum level at quantum borders or boundaries). In a classical quantum scheduler, each thread is given a quantum grant of simulated time within which it can execute independently, without any communication back to the scheduler. Only once the quantum grant of time is depleted would a thread report back to the scheduler to decrement number of active threads and to wait on a new quantum grant of time. In case of a thread waiting on an event, unlike in a classical quantum scheduler which is susceptible to active waiting or skipping to a next quantum, the thread for the quantum-based scheduler checks whether the event is already signaled. If the event is already signaled, the thread continues execution of tasks. If the event is not signaled, the thread changes its state to "wait event," reports to the quantum-based scheduler to decrement the number of active threads, hangs its execution on an operating system ("OS") event, and is released for use for other processes.

Communication with the quantum-based scheduler includes 2 actions: (i) changing the number of active threads; and (ii) checking if the number of active threads become 0. Where there is no other processing being done in a scheduler context, which limits the execution that must be thread-safe in the quantum-based scheduler to minimum, a spin-lock mechanism may be used for protecting the scheduler operation to avoid unnecessary context switches. The only case in which the quantum-based scheduler does more processing is at the quantum end, where all the threads are either waiting for some event or cannot proceed before the next quantum grant is provided. A quantum boundary is the sequential part of execution, serving the purpose of ensuring that all the threads execute in parallel with respect to a simulated time with the precision of a single quantum. This means that there is no other thread that will be trying to access a thread-safe area of the quantum-based scheduler at that time and no resources would be wasted. At a quantum boundary, the quantum-based scheduler also checks for an end of simulation condition (e.g., all threads finished or crashed), a potential deadlock situation (e.g., the number of threads waiting on a new quantum grant is 0). Because the quantum-based scheduler is aware of the threads being blocked on events, it is safe for a thread to continue hanging on an event across a quantum boundary. At the end of the quantum, the quantum-based scheduler provides new quantum grants of time to all the threads, which will resume processing. Active waiting or skipping to the next quantum by the threads may also be avoided.

Thread events are sent with information of local simulation time of the sender thread. Local simulation time of the sender thread may be calculated as a last quantum grant time plus a simulated time that is already spent by the sender thread, up to the moment of sending a thread event. As a receiver thread is not aware of how much simulated time has progressed during its event-wait, the simulated time provided with event signaling may be used to reconstruct its local simulated time irrespectively if the event was signaled within the same quantum or in the next quantum. In resuming processing, a thread may also inform the quantum-based scheduler to increase the number of active threads. The multithreaded quantum-based scheduler may be used for simulation of any physical, interdependent events, processes, and/or durations (not limited to hardware and device simulations), thus allowing for efficient utilization of parallel processing hosts. In examples, the quantum-based scheduler may be applied to simulating financial processes, transportation processes, logistics processes, network propagation processes, or any other processes with multiple, timed, and interdependent actors.

Various modifications and additions can be made to the embodiments discussed without departing from the scope of the disclosed techniques. For example, while the embodiments described above refer to particular features, the scope of the disclosed techniques also includes embodiments having different combinations of features and embodiments that do not include all of the above-described features.

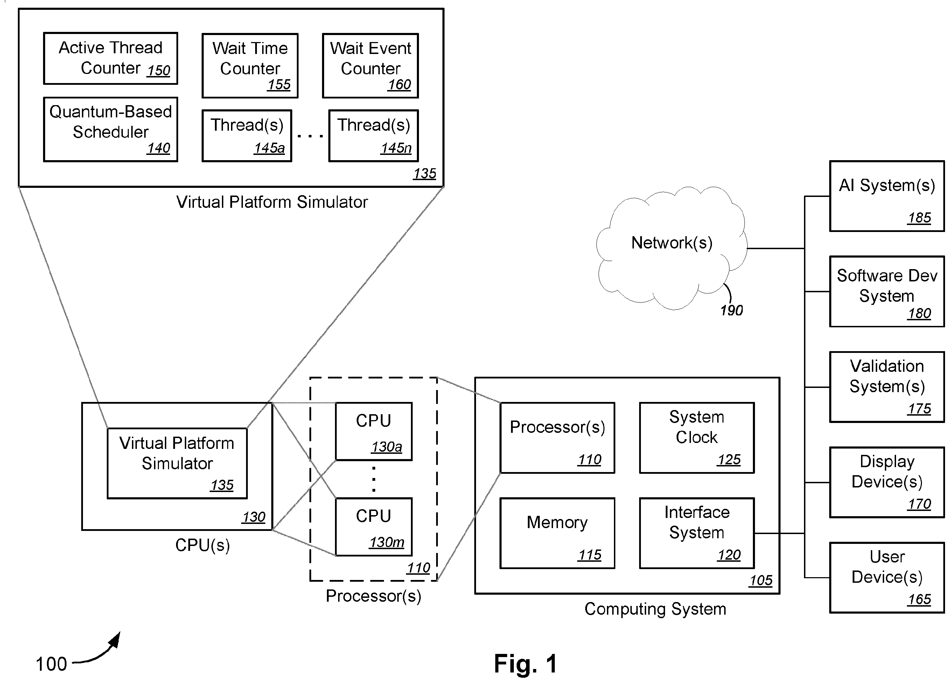

We now turn to the embodiments as illustrated by the drawings. Figs. 1-5 illustrate some of the features of a method, system, and apparatus for implementing system scheduler operations, and, more particularly, to methods, systems, and apparatuses for implementing efficient multithreaded quantum-based scheduler with time simulation, as referred to above. The methods, systems, and apparatuses illustrated by Figs. 1-5 refer to examples of different embodiments that include various components and steps, which can be considered alternatives or which can be used in conjunction with one another in the various embodiments. The description of the illustrated methods, systems, and apparatuses shown in Figs. 1-5 is provided for purposes of illustration and should not be considered to limit the scope of the different embodiments.

Fig. 1 depicts an example system 100 for implementing efficient multithreaded quantum-based scheduler with time simulation. System 100 includes a computing system 105, which includes a processor(s) 110, a memory 115, interface system 120, and system clock 125. In some examples, the processor(s) 110 includes one or more central processing units ("CPUs") 130a-130m (collectively, "CPUs 130"). In some cases, one or a combination of multiple CPUs 130 may be used to execute or run a virtual platform simulator 135. In examples, the virtual platform simulator 135 includes a quantum-based scheduler 140 and a plurality of threads 145a-145n (collectively, "threads 145"). Herein, *m* and *n* are non-negative integer numbers that may be either all the same as each other, all different from each other, or some combination of same and different (e.g., one set of two or more having the same values with the others having different values, a plurality of sets of two or more having the same value with the others having different values). The quantum-based scheduler 140 is configured to grant each of the plurality of threads 145 with a quantum of time (also referred to herein as "quantum grant of time"). In some cases, the quantum-based scheduler 140 is further configured to synchronize simulated time across the plurality of simulated threads and/or to verify a simulated time of each of the plurality of simulated threads. In some instances, quantum-based scheduler 140 may utilize system time from system clock 125 to perform its operations.

As used herein, a quantum of time may refer to a period between synchronization points among the plurality of threads 145, and may include any suitable value including 1's ns, 10's ns, 100's ns, 1's µs, 10's µs, 100's µs, 1's ms, 10's ms, or 100's ms, or one or more values in a range of values between 1 ns and 1 s, or greater. The quantum of time is selected based on a trade-off between precision of annotation and performance of the virtual platform simulator system. In an example, each quantum of time is selected to be the same value as the quantum of time in other quantum grants of time in a given simulation session, in some cases, taking into account the precision of annotation and performance of the virtual platform simulator system. Time annotations are function calls in the code indicating how long certain executed functionalities would take in a real system, which is used by a simulator to progress the time for a given thread. Such progression of time may have a certain precision or granularity. In an example, for execution of a single instruction on a modelled processor that would take 5 ns, the simulator can annotate 5 ns every time that the model processes a single instruction, or the simulator can do so every 100 instructions and can annotate accordingly 500 ns at once. This may be a chosen annotation granularity or precision and, in some cases, may remain unchanged at runtime. In examples, selecting a quantum includes defining a value of simulated time during which threads are allowed to run independently, or potentially in parallel. In some cases, the simulator may select a quantum that is not lower than the lowest annotation value (or lowest granularity of annotation). In some examples, selecting an infinite (or a sufficiently high value) quantum effectively turns the simulation into a fully event driven simulation session. The balance may include selecting a quantum value that is between highest granularity of annotation and infinity. In some cases, "precision of annotation" is not changed. In another example, each quantum of time among one or more of the quantum grants of time is dynamically selected based on measurements of how often the plurality of simulated threads have been signaling each other during a previous quantum of time. In the case that the threads do not communicate very frequently relative to the selected quantum (e.g., for inter-thread events sent once every 5 quantum grants of time), the simulator may re-synchronize less frequently between all threads, and the simulator may increase the quantum size to limit overhead costs. Similarly, if threads are communicating frequently compared with the quantum size (e.g., 100 events per quantum), the simulator may adjust the quantum size to ensure more simulated time-precision, as overhead may likely be less compared with a number of events already in the system. The quantum value may be determined at runtime based on gathered statistics including (a) measuring a number of events per quantum per thread, measured only on active threads in a given quantum, slowly adjusted towards a given optimum target number; (b) based on an expected execution speed of simulating a single quantum; and/or (c) based on the slowest threads. In some examples, for simulations that are executed twice in succession, with an infinite quantum for verifying functional correctness or synchronization correctness or with a smallest meaningful quantum to maximize profiling precision, an optimal quantum size may be selected based on the measured simulation time or profiling precision.

In some cases, dynamic selection of the quantum of time may be based on heuristics (e.g., using trial and error, a rule of thumb, or an educated guess). For trial-and-error heuristics, a first value of the quantum of time may be selected (either randomly, using a default value, or based on an educated guess), and may use subsequent measurements to finetune the values for selecting a second and subsequent values of the quantum of time. For rule of thumb heuristics, an example rule of thumb may include selecting a first set value (e.g., 100 µs) for measurements indicating a first range of number of expected simulated threads (e.g., 3-5 threads), selecting a second set value (e.g., 50 µs) for measurements indicating a second range of number of expected simulated threads (e.g., greater than 5 threads), or selecting a third set value (e.g., 200 µs) for measurements indicating a third range of number of expected simulated threads (e.g., less than 3 threads). For educated guess heuristics, one or more educated guesses may include guesses by the scheduler (or by a user) regarding likely values for the quantum of time depending on particular measured values, in some cases, based on historical data and/or prior analyses of a relationship between measured values and the quantum of time. In other examples, for a system that does not have frequent interactions between threads, the quantum of time may be selected to be larger unless the system relies on some timing that is required for other system operations. With a sufficient large quantum of time (e.g., seconds, minutes, hours, days, or years), the system becomes a fully event-based system. For a system that has frequent interactions between threads, however, having a smaller quantum of time ensures better synchronization amongst the threads and provides for improved timing, but is more resource intensive thus potentially affecting overall performance of the system.

The plurality of threads 145, when executed by one or more of the CPUs 130, concurrently performs a corresponding plurality of assigned simulation tasks, including at least one of time annotation, time simulation, task processing, or assembling instructions for control processors. In some cases, the virtual platform simulator 135 further includes an active thread counter 150, a wait time counter 155, and/or a wait event counter 160. The active thread counter 150 is configured to track a count of the number of active threads, e.g., during each simulation session or each time a function call, corresponding data, or another method for informing the scheduler (collectively, "a message") is received by the quantum-based scheduler 140. The wait time counter 155 is configured to track a count of the number of simulated threads that are waiting for an additional quantum grant of time to perform its current assigned simulation task. The wait event counter 160 is configured to track a count of the number of simulated threads that are waiting for an event signal from another simulated thread among the plurality of simulated threads.

In examples, the system 100 further includes at least one of one or more user devices 165, one or more display devices 170, one or more validation systems 175, software development system 180, one or more artificial intelligence ("AI") systems 185, and/or network(s) 190. The interface system 120 may interface between computing system 105 and each of one or more of these devices or systems, and may output or send results of the virtual platform simulator 135 to the one or more of these devices or systems for use as inputs and/or feedback for these devices or systems. In some examples, the one or more user devices 165 include at least one of a desktop computer, a laptop computer, a tablet computer, a smart phone, or a mobile phone. The one or more display device 170 each includes one of a touchscreen display, a non-touchscreen display, a monitor, a television, a display screen of one of the user devices 165. The validation system(s) 175 is a system for validating hardware or software components. The software development system 180 is a system for developing and debugging software. The AI system(s) 185 is a system for performing AI functions. The network(s) 190 may each include at least one of a distributed computing network, such as the Internet, a private network, a commercial network, or a cloud network, and/or the like, and may communicatively couple the computing system 105 with remote devices or systems similar to devices and/or systems 165-185.

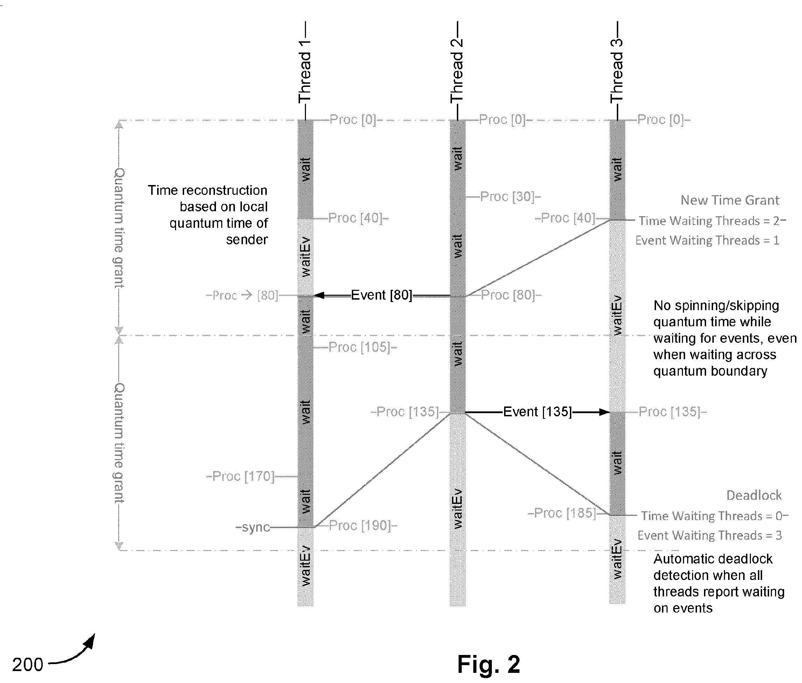

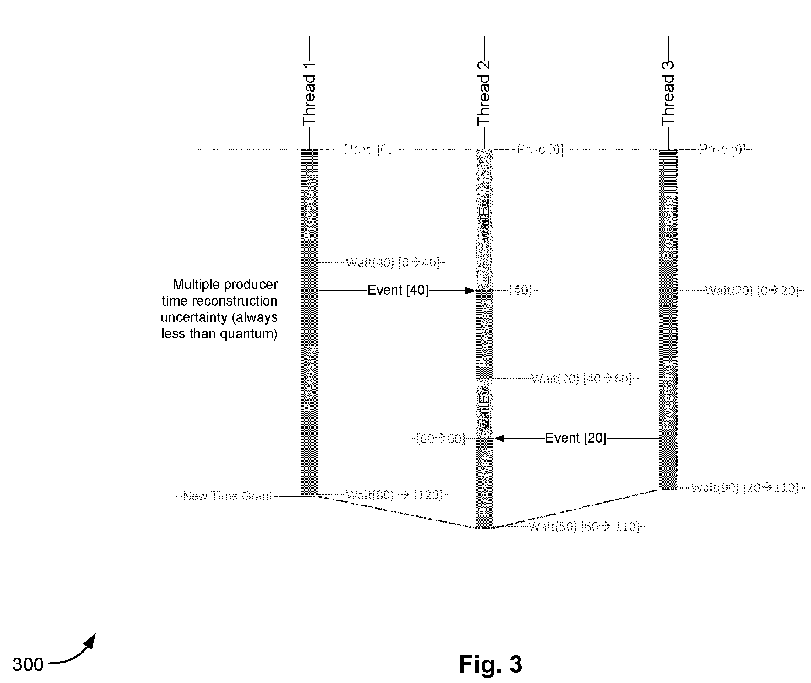

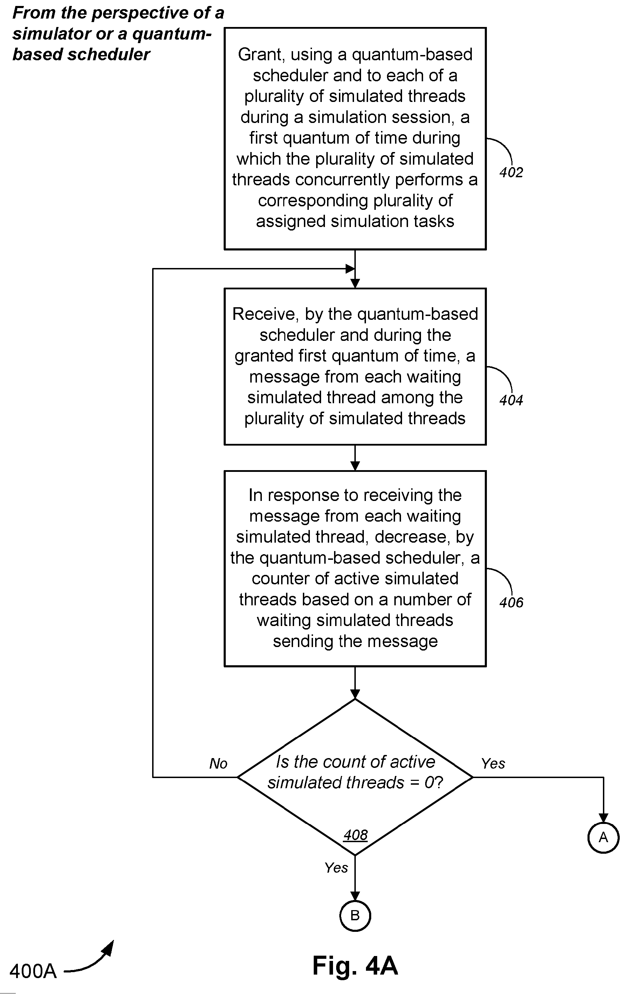

In operation, the virtual platform simulator 130, the quantum-based scheduler 140, and/or the threads 145a-145n, as executed or run by one or more of the CPUs 130a-130m, may perform methods for implementing efficient multithreaded quantum-based scheduler with time simulation, as described in detail with respect to Figs. 2-4G. For example, example sequence flow 200 as described below with respect to Fig. 2 illustrates time reconstruction of a multithreaded time simulation using the quantum-based scheduler as described herein. Example sequence flow 300 as described below with respect to Fig. 3 illustrates a multiple producer time reconstruction scenario. Example sequence flow 200 of Fig. 2, example sequence flow 300 of Fig. 3, and example methods 400A and 400B as described below with respect to Figs. 4A-4G may be applied with respect to the operations of system 100 of Fig. 1.

In some aspects, the system and techniques, as described herein, provide inner visibility for platform simulations, including deadlock detection, event management between threads, obtaining states of threads, and speed of operation with use of multithreading versus use of a single host thread while addressing issues with conventional multithreading simulation techniques.

Figs. 2 and 3 each illustrates time reconstruction of a multithreaded time simulation using the quantum-based scheduler. Although Figs. 2 and 3 depict three threads, this is merely for purposes of illustration, and the various embodiments are not limited to only three threads. Any suitable number of threads may be used when implementing time simulation or the multithreaded quantum-based scheduler as described herein. Herein, quantum units refer to sub-quantum units of time. For instance, if a quantum is 100 µs, and there are 100 quantum units in the quantum, then each quantum unit is equivalent to or corresponds to 1 µs. As described herein, the quantum that is granted to the threads may be selected to be any suitable value, which may be dynamically changes in some cases. For progress of threads in simulated time such as shown in Figs. 2 and 3, each thread, when scheduled to run, executes its functionality (e.g., user code) in "no-time" - that is, all functionality is done in zero simulation time. A user would annotate how long the given portion of the functionality would have taken on real hardware (or more generally, how long the executed functionality would take in the real-timed world). A time annotation function is provided to the user by the simulator framework. Calling the time annotation function is the only way for the thread to progress in simulated time. Each thread keeps its current simulated time value internally and increments the simulated time value each time the user calls the time annotation function. At the moment the time annotation function is called, the internal time value is compared to the grant limit (e.g., quantum grant of time) to determine the wait on grant condition. Internal thread time is also used for time-reconstruction when signaling events to other threads. In Figs. 2 and 3, "wait" or "processing" denote time annotations corresponding to scheduled or estimated time that each thread would take (in real-time) to execute its functionality.

Fig. 2 depicts an example sequence flow 200 for multithreaded operation when implementing efficient multithreaded quantum-based scheduler with time simulation. Fig. 2 illustrates time reconstruction of a multithreaded time simulation using the quantum-based scheduler. For the time reconstruction, the simulated threads (in this case, threads 1, 2, and 3) are running in parallel from quantum unit [0] until quantum unit [190] when detection of potential deadlock occurs. As shown in Fig. 2, two quantum time grants are shown, with the first quantum time grant to quantum unit [100] and the second quantum time grant to quantum unit [200].

In the example of Fig. 2, at quantum unit [0], a quantum-based scheduler (e.g., quantum-based scheduler 140) grants a quantum of time (or provides a quantum time grant) to all three threads. Thread 1 waits or processes a task from quantum unit [0] to quantum unit [40], then waits for an event from another thread. While waiting for an event, thread 1 relies only on its local simulation time, which may drift or change relative to the simulation times of other threads. Meanwhile, thread 2 waits or processes a task from quantum unit [0] to quantum unit [30], and waits or processes a task from quantum unit [30] to quantum unit [80], at which point, it sends an event signal to thread 1. Meanwhile, thread 3 waits or processes a task from quantum unit [0] to quantum unit [40], then waits for an event from another thread. At quantum unit [80], both threads 1 and 2 may each determine that its next task will take longer than the quantum grant of time (that is, may require time beyond the quantum that it is granted, in this case quantum unit [100]; or may cross a quantum border or boundary should it attempt to perform the task), and may wait for additional quantum grants of time before proceeding.

Each time that each thread waits for an event, waits for additional quantum grants of time, and/or sends an event signal, the thread sends a message to the quantum-based scheduler, which is then able to track the status of the threads. For instance, at quantum unit [80] for threads 1 and 2 and at quantum unit [40] for thread 3, the quantum-based scheduler determines that two threads are waiting for additional quantum grants of time, while one thread is waiting on an event. The quantum-based scheduler, determining that at least one thread is waiting for additional quantum grants of time, would grant another quantum of time, in this case, to grant each thread a quantum of time up to quantum unit [200].

In this manner, because the quantum-based scheduler is kept updated with the status of the threads via messages reported or sent by the threads, and thus is able to avoid issues with spinning in place (or "burning time") or skipping quantum time in classical quantum schedulers. As an example, as synchronization can happen only on a quantum border in classical quantum schedulers, a consumer thread that needs to wait for an event can either spin-check (or spin in place) for an update, moving simulated time slowly forward, or decide to skip execution until the next quantum. The former (i.e., spinning) causes simulation performance degradation, while the latter (i.e., skipping) introduces time approximation errors of up to a quantum size.

After receiving the quantum grant of time to quantum unit [200], thread 1 waits or processes a task from quantum unit [80] to quantum unit [105], waits or processes a task from quantum unit [105] to quantum unit [170], and waits or processes yet another task from quantum unit [170] to quantum unit [190]. At quantum unit [190], thread 1 waits for an event from another thread. Meanwhile, thread 2 waits or processes a task from quantum unit [80] to quantum unit [135], at which point, thread 2 sends an event signal to thread 3, then waits for another event from another thread. Meanwhile, thread 3 waits until quantum unit [135], at which point it receives the event signal from thread 2, and waits or processes a task from quantum unit [135] to quantum unit [185]. At quantum unit [185], thread 3 waits for an event from another thread. As described above, the quantum-based scheduler is kept updated with the statuses of the threads, and determines at quantum unit [190] for thread 1, at quantum unit [135] for thread 2, and at quantum unit [185] for thread 3 that none of the threads are waiting for additional quantum grants of time to perform tasks and that all three threads are waiting for an event, which is indicative of a potential deadlock situation. Threads waiting on events are unable to advance, as that would break the logic. The quantum-based scheduler may determine an end of simulation condition, and may accordingly end the time simulation, when it detects the situation where all threads are waiting for an event. In this manner, because all threads report to the quantum-based scheduler, or otherwise keep the quantum-based scheduler updated, on a sub-quantum level, automatic deadlock detection capability may be achieved.

In some aspects, when a thread is blocked on event, it reports back to the scheduler informing the scheduler that it is in a wait-event state. The scheduler decrements the number of running threads. In this way, the quantum may be finalized, even if some threads are waiting on events. There is no need for any thread to slowly progress time while waiting, and thus is one of the main benefits over "classic" quantum-based scheduling techniques where such polling would be needed to reach the next quantum grant. Event waiting threads are still receiving quantum grants (e.g., the time value until which they are allowed to execute), and they will continue until the next grant immediately after receiving an event signal that the threads are waiting on and after reconstructing their local time.

In an example, with a quantum grant size of 100, and with threads A and B running, all threads receive the quantum grant to run until time [100]. At this point, the number of running threads is 2. Thread A at local time [23] reached a moment when it waits on an event, and reports to the scheduler. At his point, the number of running threads is 1. Thread B continues to run through to time [100], and reports to the scheduler that it is waiting on a new quantum grant of time. At this point, the number of running threads is 0. The scheduler detects no running threads, and checks whether any thread is waiting on a new quantum grant of time grant. In this case, at least thread B is waiting on a new quantum grant of time, and based on such determination, the scheduler provides, to all threads, the new quantum grant of time to run until time [200]. At this point, the number of running threads is 1. Thread B, at local time [154], sends an event signal to thread A. Thread A updates its local time to time [154], and resumes execution, as the quantum grant of time for thread A is now until time [200]. At this point, the number of running threads is 2. And so on. Here, thread A need not check its time or progress its time; thread A is suspended until the event signal is received, even if it happens N quantum grants later. In the case that thread B waits on an event before sending one, both threads would be in a wait-event state, and based on corresponding messages that are reported or sent by both threads, the scheduler would detect a deadlock situation immediately.

Fig. 3 depicts another example sequence flow 300 for multithreaded operation when implementing efficient multithreaded quantum-based scheduler with time simulation. Fig. 3 illustrates another time reconstruction of a multithreaded time simulation using the quantum-based scheduler, in this case, depicting a situation with multiple producer threads and a single consumer thread. Simulated time reconstruction has limitations in case of multiple producer threads and single consumer threads of event. In such situations, as producer threads may not be synchronized with other threads, an event signaled with a later simulated time may come earlier than an event signaled with an earlier simulated time. In that situation, if the simulated time of the event is earlier than the consumer thread local time, the event simulated time is ignored. Multiple producer thread and single consumer thread situations, however, are not a common case in hardware processing, as there are mostly dedicated communication channels between hardware components (e.g., direct queues). Also, multiple producer and single consumer situations with unsynchronized producers indicate that the order of events received at a consumer thread is not relevant (or there is a synchronization bug in the system). Finally, the simulated time error introduced by this situation cannot be more than a quantum time.

With reference to Fig. 3, for the time reconstruction, the simulated threads (in this case, threads 1, 2, and 3) are running in parallel from quantum unit [0] until beyond quantum unit [120]. As shown in Fig. 3, two quantum time grants are shown, with the first quantum time grant to quantum unit [120] and the second quantum time grant beyond quantum unit [120]. In the example of Fig. 3, at quantum unit [0], a quantum-based scheduler (e.g., quantum-based scheduler 140) grants a quantum of time (or provides a quantum time grant) to all three threads. Thread 1 processes a task from quantum unit [0] to quantum unit [30], then waits for until quantum unit [40], at which point thread 1 sends an event signal to thread 2, and then continues to process another task from quantum unit [40] to quantum unit [80]. Meanwhile, thread 2 waits for an event from quantum unit [0] to quantum unit [40], at which point it receives the event signal from thread 1. While waiting for an event, thread 2's local simulation time may not be updating accurately or precisely (or at all), and thus when it receives the event signal (which includes thread 1's local simulation time) and determines that thread 1's local simulation time is greater than its own local simulation time, thread 2 uses thread 1's local simulation time to synchronize its own local simulation time. Thread 2 processes a task from quantum unit [40] until quantum unit [60], at which point it waits for an event from another thread. Meanwhile, thread 3 processes a task from quantum unit [0] to quantum unit [20], at which point thread 3 sends an event signal to thread 2. At quantum unit [60] (which is not updated as it waited for an event), thread 2 receives the event signal from thread 3. However, thread 3's local simulation time is quantum unit [20], which is less than thread 2's local quantum unit of [60], thus thread 2 ignores thread 3's local simulation time, and processes another task until quantum unit [110]. Meanwhile, thread 3 processes another task until quantum unit [110]. At quantum unit [120] for thread 1 and at quantum unit [110] for threads 2 and 3, the quantum-based scheduler determines that all three threads are waiting for additional quantum grants of time. The quantum-based scheduler, determining that at least one thread is waiting for additional quantum grants of time, grants another quantum of time to all three threads, while synchronizing their local simulation times. In this manner, the threads are able to ignore erroneous local simulation times from threads that provide incorrect or mis-synchronized local simulation times.

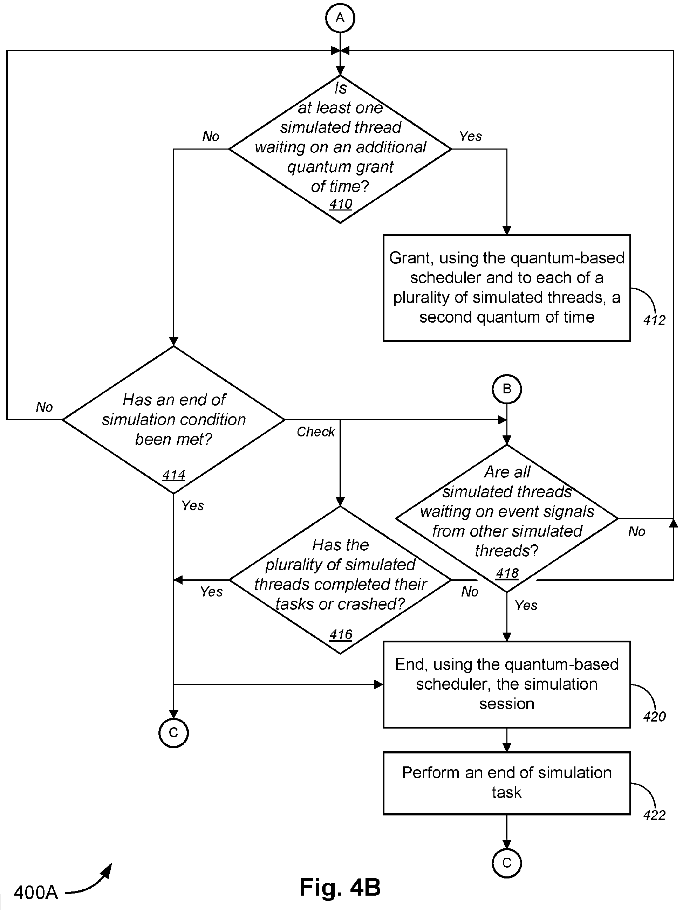

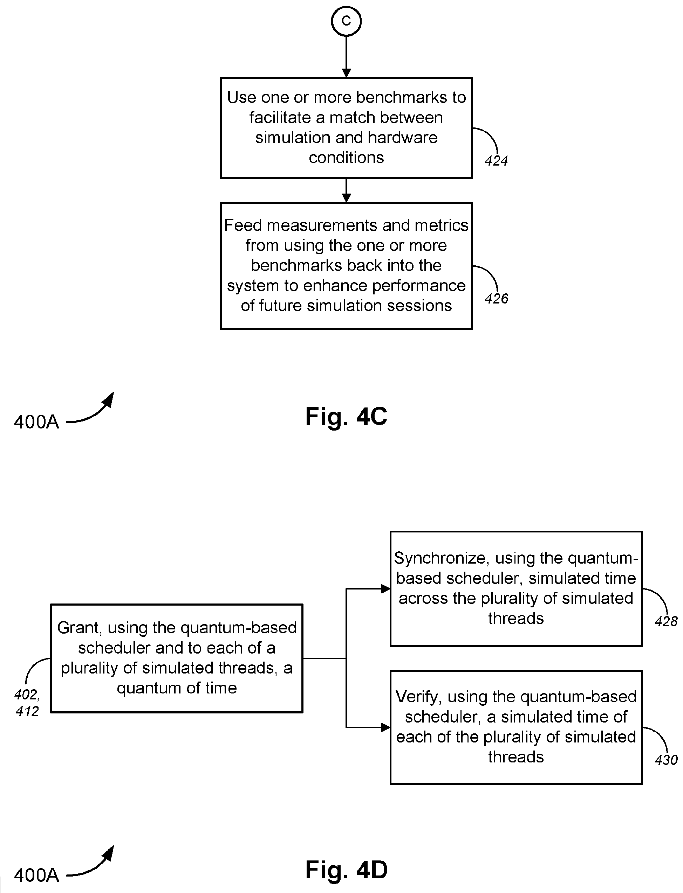

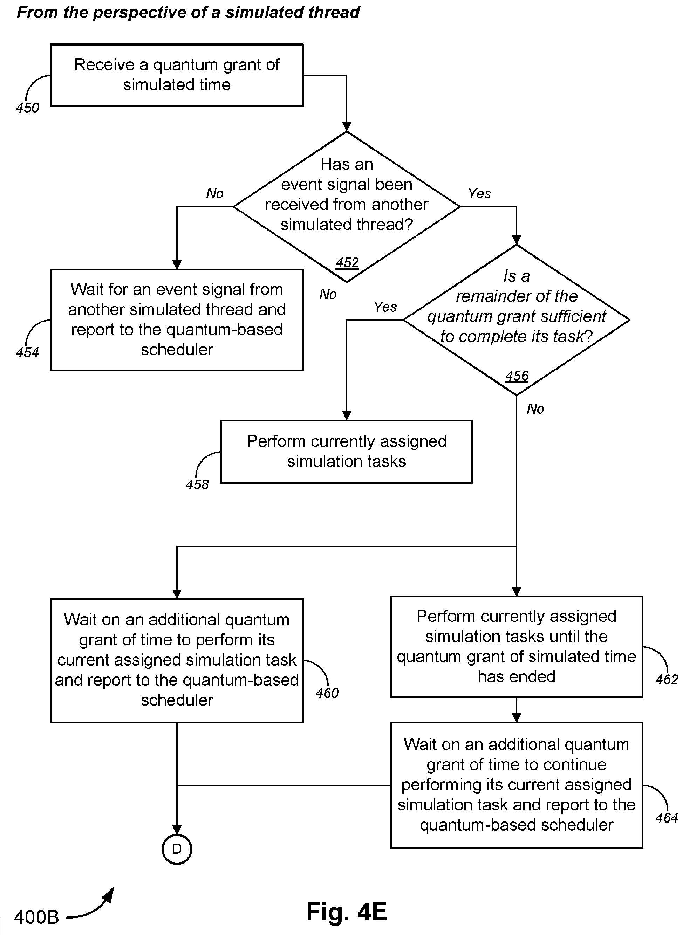

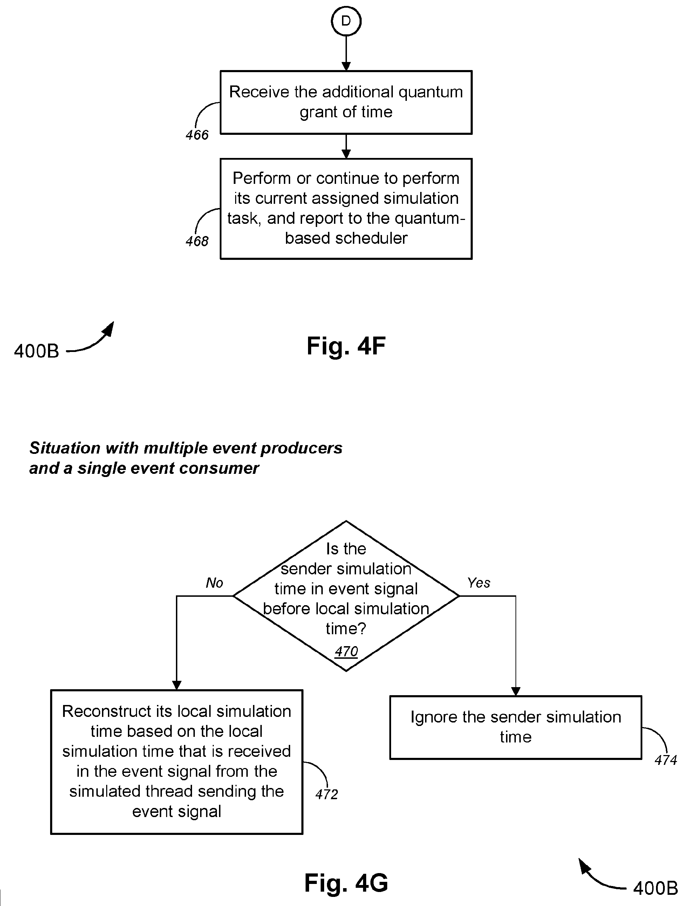

Figs. 4A-4G depict various example methods 400A and 400B for implementing efficient multithreaded quantum-based scheduler with time simulation. Method 400A (in Figs. 4A-4D) is directed to implementing efficient multithreaded quantum-based scheduler with time simulation from the perspective of a simulator (e.g., a virtual platform simulator) or a quantum-based scheduler, which are as described above with respect to Fig. 1. Method 400B (in Figs. 4E-4G) is directed to implementing efficient multithreaded quantum-based scheduler with time simulation from the perspective of a simulated thread among a plurality of simulated threads, which are described above with respect to Figs. 1-3. Method 400A of Fig. 4A continues onto Fig. 4B following the circular marker denoted, "A," or the circular marker denoted, "B. " Method 400A of Fig. 4B continues onto Fig. 4C following the circular marker denoted, "C." Method 400B of Fig. 4E continues onto Fig. 4F following the circular marker denoted, "D."

With reference to Fig. 4A, method 400A, at operation 402, includes granting, using a quantum-based scheduler and to each of a plurality of simulated threads during a simulation session, a first quantum of time during which the plurality of simulated threads concurrently performs a corresponding plurality of assigned simulation tasks. In an example, the first quantum of time is a quantum of time that is granted to the plurality of simulated threads at a beginning of the simulation session. Alternatively, the first quantum of time is a quantum of time that is granted to the plurality of simulated threads after one or more previous quantum grants of time to the plurality of simulated threads during the simulation session. In some examples, the quantum-based scheduler is part of a virtual platform simulator system. In examples, the simulation session is used to perform at least one of:
(1) modelling multi-context system behavior;
(2) tracing execution of the plurality of assigned simulation tasks by the plurality of simulated threads;
(3) reconstructing timing of each of the plurality of simulated threads;
(4) annotating time for each of the plurality of simulated threads;
(5) facilitating debugging of the plurality of assigned simulation tasks;
(6) validating at least one of hardware algorithms, synchronization of the plurality of simulated threads, or system kernels;
(7) finetuning timing from the simulation session to match hardware behavior; or
(8) determining how long an average instruction on the processor would take to execute.

In some examples, modelling multi-context system behavior includes mapping to separate threads or processes. In one or more of the various examples, parallel execution of the simulation is performed in a time-annotated system, in some cases, where precision in terms of time annotation is statically or dynamically adjusted compared with quantum size.

At operation 404, method 400A includes receiving, by the quantum-based scheduler and during the granted first quantum of time, a message from each waiting simulated thread among the plurality of simulated threads, the message indicating that the waiting simulated thread is either waiting on an additional quantum grant of time to perform its current assigned simulation task or waiting for an event signal from another simulated thread among the plurality of simulated threads. In examples, the assigned simulation tasks include at least one of time annotation, time simulation, task processing, or assembling instructions for control processors. In some examples, the event signal includes information of a local simulation time of the simulated thread sending the event signal. In some instances, the local simulation time is calculated based on a sum of a time corresponding to a preceding quantum grant of time and simulated time spent by the simulated thread sending the event signal up to a moment of sending the event signal. In some cases, at least one simulated thread is actively performing its assigned simulation tasks during an entirety of at least the first quantum of time, which enables time to be continuously tracked during the quantum of time and to be shared with other simulated threads when sending event signals to other simulated threads, thereby enabling better tracking of time at the sub-quantum level amongst multiple simulated threads.

At operation 406, method 400A includes, in response to receiving the message from each waiting simulated thread, decreasing, by the quantum-based scheduler, a counter of active simulated threads based on a number of waiting simulated threads sending the message. At operation 408, method 400A includes determining whether there are no more active simulated threads among the plurality of simulated threads based on the counter of active simulated threads (e.g., whether a count of active simulated threads is zero). Based on a determination that there is at least one active simulated thread among the plurality of simulated threads based on the counter of active simulated threads (e.g., that the count of active simulated threads > 0), method 400A returns to the process at operation 404. Based on a determination that there are no more active simulated threads among the plurality of simulated threads based on the counter of active simulated threads (e.g., that the count of active simulated threads equals 0), method 400A either continues onto the process at operation 410 in Fig. 4B following the circular marker denoted, "A," or continues onto the process at operation 414 in Fig. 4B following the circular marker denoted, "B."

At operation 410 in Fig. 4B (following the circular marker denoted, "A," in Fig. 4A), method 400A includes determining whether at least one simulated thread is waiting on an additional quantum grant of time to perform its current assigned simulation task. Based on a determination that at least one simulated thread is waiting on an additional quantum grant of time to perform its current assigned simulation task, method 400A continues onto the process at operation 412. At operation 412, method 400A includes granting, using the quantum-based scheduler and to each of a plurality of simulated threads, a second quantum of time. Based on a determination that at least one simulated thread is waiting on an additional quantum grant of time to perform its current assigned simulation task, method 400A continues onto the process at operation 414. At operation 414, method 400A includes determining whether an end of simulation condition has been met. In an example, determining whether an end of simulation condition has been met (at operation 414) includes checking whether the plurality of threads has each either completed its assigned simulated tasks or crashed (at operation 416) and/or checking whether all simulated threads are waiting on event signals from other simulated threads (indicative of a potential deadlock situation having occurred) (at operation 418). Based on a determination that an end of simulation condition has not been met (at operation 414) (e.g., that not all simulated threads have either completed their tasks or crashed (at operation 416), and/or that not all simulated threads are waiting on event signals from other simulated threads (at operation 418)), method 400A returns to the process at operation 410. Based on a determination that an end of simulation condition has been met (at operation 414) (e.g., that all simulated threads have either completed their tasks or crashed (at operation 416)), method 400A either continues onto the process at operation 420 or continues onto the process at operation 424 in Fig. 4C following the circular marker denoted, "C." Based on a determination that each simulated thread in the plurality of simulated threads is waiting on event signals from other simulated threads (at operation 418), method 400A continues onto the process at operation 420. At operation 420, method 400A includes ending, using the quantum-based scheduler, the simulation session and performing an end of simulation task. At operation 422, method 400A includes performing an end of simulation task, which may include at least one of:
(a) logging a deadlock situation;
(b) displaying information regarding the ending of the simulation session on a display screen of a user device;
(c) providing full inspection capability to a user;
(d) capturing a state of the plurality of simulated threads in simulated time;
(e) detecting race conditions of the plurality of simulated threads;
(f) tracing, logging, and debugging errors during the simulation session;
(g) providing results of the simulation session to a debugger;
(h) providing results of the simulation session to an analysis system to validate at least one of hardware algorithms, synchronization of the plurality of simulated threads, or system kernels; or
(i) providing results of the simulation session to another system to fine tune timing from the simulation session to match hardware behavior.

In some cases, method 400A may continue onto the process at operation 424 in Fig. 4C following the circular marker denoted, "C." At operation 424 in Fig. 4C (following the circular marker denoted, "C," in Fig. 4B), method 400A may include using one or more benchmarks to facilitate a match between simulation and hardware conditions. At operation 426, method 400A may include feeding measurements and metrics from using the one or more benchmarks back into the system to enhance performance of future simulation sessions.

Referring to Fig. 4D, each time that a quantum of time is granted to the plurality of simulated threads (e.g., at operation 402 and/or 412), method 400A further includes at least one of: synchronizing, using the quantum-based scheduler, simulated time across the plurality of simulated threads (at operation 428); or verifying, using the quantum-based scheduler, a simulated time of each of the plurality of simulated threads (at operation 430). In examples, verifying the simulated time of each of the plurality of simulated threads (at operation 430) may be performed based on time stamps of events that are signaled to the simulated threads. In an example, each quantum of time (including the first quantum of time and the second quantum of time) is selected to be the same value as the quantum of time in other quantum grants of time, based on a balance between precision of annotation and performance of the virtual platform simulator system. In another example, each quantum of time among one or more of the quantum grants of time is dynamically selected based on measurements of how often the plurality of simulated threads have been signaling each other during a previous quantum of time.

Turning to Fig. 4E, method 400B, which is from the perspective of a simulated thread, includes, at operation 450, receiving a quantum grant of simulated time. At operation 452, determining whether an event signal has been received from another simulated thread among the plurality of simulated threads. Based on a determination that an event signal has not been received from another simulated thread, method 400B continues onto the process at operation 454. At operation 454, method 400B includes waiting for an event signal from another simulated thread and reporting to the quantum-based scheduler, e.g., either to indicate that it is waiting on an event signal to perform current assigned simulation tasks or to indicate to decrement a counter of active threads. Based on a determination that an event signal has been received from another simulated thread, method 400B continues onto the process at operation 456, at which method 400B includes determining whether a remainder of the quantum grant of simulated time is sufficient to complete its current assigned simulation task. Based on a determination that a remainder of the quantum grant of simulated time is sufficient to complete its current assigned simulation task, method 400B continues onto the process at operation 458, at which method 400B includes performing currently assigned simulation tasks. Based on a determination that a remainder of the quantum grant of simulated time is insufficient to complete its current assigned simulation task, method 400B either continues onto the process at operation 460 or continues onto the process at operation 462. At operation 460, method 400B includes waiting on an additional quantum grant of time to perform its current assigned simulation task and reporting to the quantum-based scheduler either to indicate that it is waiting on an additional quantum grant of time to perform its current assigned simulation task or to indicate to decrement a counter of active threads. Method 400B continues onto the process at operation 466 in Fig. 4F following the circular marker denoted, "D." At operation 462, method 400B includes performing currently assigned simulation tasks until the quantum grant of simulated time has ended. At operation 464, method 400B includes waiting on an additional quantum grant of time to continue performing its current assigned simulation task, and reporting to the quantum-based scheduler either to indicate that it is waiting on an additional quantum grant of time to continue performing its current assigned simulation task or to indicate to decrement a counter of active threads. Method 400B continues onto the process at operation 466 in Fig. 4F following the circular marker denoted, "D."

At operation 466 in Fig. 4F (following the circular marker denoted, "D," in Fig. 4E), method 400B includes receiving the additional quantum grant of time. At operation 468, method 400B includes performing or continuing to perform its current assigned simulation task, and reporting to the quantum-based scheduler either to indicate that it is resuming processing or to indicate to increase the counter of active threads.

Referring to Fig. 4G, which is directed to a situation with multiple event producers and a single event consumer among the plurality of simulated threads. At operation 470, method 400B includes determining whether a sender simulation time of each of multiple event producers, as received in an event signal from each event producer, is before its local simulation time. Based on a determination that the sender simulation time that is received in the event signal is at or later than its local simulation time, method 400B continues onto the process at operation 472. At operation 472, method 400B includes reconstructing its local simulation time based on the local simulation time that is received in the event signal from the simulated thread sending the event signal. Based on a determination that the sender simulation time that is received in the event signal is before its local simulation time, method 400B continues onto the process at operation 474. At operation 474, method 400B includes ignoring the sender simulation time.

While the techniques and procedures in methods 400A, 400B are depicted and/or described in a certain order for purposes of illustration, it should be appreciated that certain procedures may be reordered and/or omitted within the scope of various embodiments. Moreover, while the methods 400A, 400B may be implemented by or with (and, in some cases, are described below with respect to) the systems, examples, or embodiments 100, 200, and 300 of Figs. 1, 2, and 3, respectively (or components thereof), such methods may also be implemented using any suitable hardware (or software) implementation. Similarly, while each of the systems, examples, or embodiments 100, 200, and 300 of Figs. 1, 2, and 3, respectively (or components thereof), can operate according to the methods 400A, 400B (e.g., by executing instructions embodied on a computer readable medium), the systems, examples, or embodiments 100, 200, and 300 of Figs. 1, 2, and 3 can each also operate according to other modes of operation and/or perform other suitable procedures.

As should be appreciated from the foregoing, the present technology provides multiple technical benefits and solutions to technical problems. For instance, simulating execution of software on hardware components generally raises multiple technical problems. For example, one technical problem includes spinning, in which a consumer component that needs to wait for an event, thus causing simulation performance degradation. Another technical problem includes skipping execution until the next quantum, thus introducing a time approximation error of up to the size of a quantum of time. Yet another technical problem includes potential deadlock situations that may go undetected for more than a quantum of time. The present technology provides for efficient multithreaded quantum-based scheduler with time simulation. Each time that each thread waits for an event, waits for additional quantum grants of time, and/or sends an event signal, the thread sends a message to the quantum-based scheduler, which is then able to track the status of the threads. In response to receiving the message from each waiting simulated thread, the quantum-based scheduler decreases a counter of active simulated threads based on a number of waiting simulated threads sending the message. If there are no more active simulated threads and if at least one simulated thread is waiting on an additional quantum grant of time to perform its current assigned simulation task, the quantum-based scheduler grants a second quantum of time to each of a plurality of simulated threads. If there are no more active simulated threads and if each simulated thread in the plurality of simulated threads is waiting on event signals from other simulated threads, the quantum-based scheduler ends the simulation session and performs an end of simulation task. In this manner, because the quantum-based scheduler is kept updated with the status of the threads via messages that are reported or sent by the threads, and thus is able to avoid issues with spinning in place (or "burning time") or skipping quantum time in classical quantum schedulers, while also enabling automatic deadlock detection.

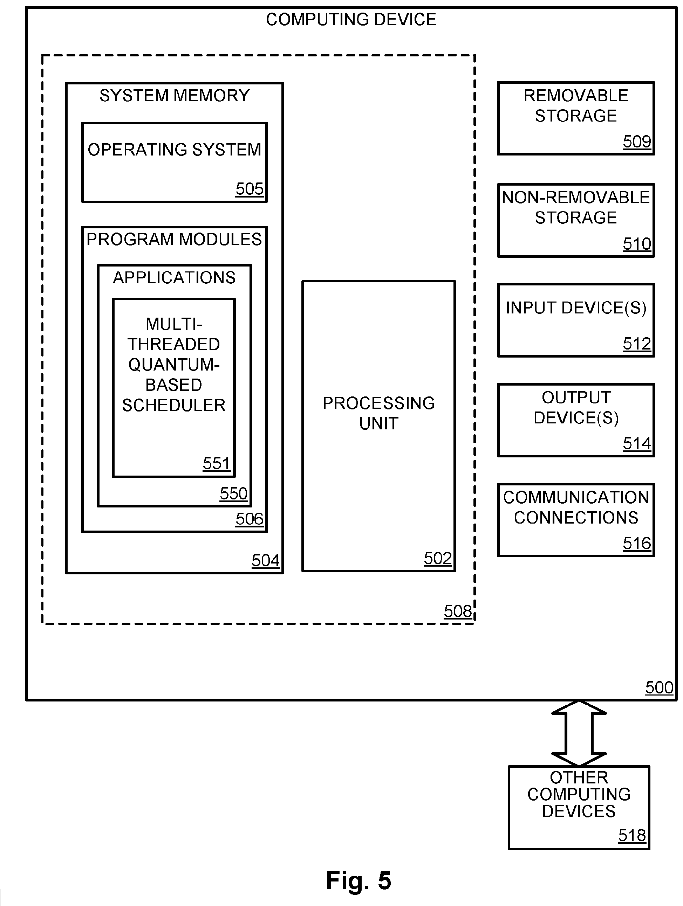

Fig. 5 depicts a block diagram illustrating physical components (i.e., hardware) of a computing device 500 with which examples of the present disclosure may be practiced. The computing device components described below may be suitable for a client device implementing the efficient multithreaded quantum-based scheduler with time simulation, as discussed above. In a basic configuration, the computing device 500 may include at least one processing unit 502 and a system memory 504. The processing unit(s) (e.g., processors) may be referred to as a processing system. Depending on the configuration and type of computing device, the system memory 504 may include volatile storage (e.g., random access memory), non-volatile storage (e.g., read-only memory), flash memory, or any combination of such memories. The system memory 504 may include an operating system 505 and one or more program modules 506 suitable for running software applications 550, such as multithreaded quantum-based scheduler 551, to implement one or more of the systems or methods described above.

The operating system 505, for example, may be suitable for controlling the operation of the computing device 500. Furthermore, aspects of the invention may be practiced in conjunction with a graphics library, other operating systems, or any other application program and is not limited to any particular application or system. This basic configuration is illustrated in Fig. 5 by those components within a dashed line 508. The computing device 500 may have additional features or functionalities. For example, the computing device 500 may also include additional data storage devices (which may be removable and/or non-removable), such as, for example, magnetic disks, optical disks, or tape. Such additional storage is illustrated in Fig. 5 by a removable storage device(s) 509 and a non-removable storage device(s) 510.

As stated above, a number of program modules and data files may be stored in the system memory 504. While executing on the processing unit 502, the program modules 506 may perform processes including one or more of the operations of the method(s) as illustrated in Figs. 4A-4G, or one or more operations of the system(s) and/or apparatus(es) as described with respect to Figs. 1-3, or the like. Other program modules that may be used in accordance with examples of the present disclosure may include applications such as electronic mail and contacts applications, word processing applications, spreadsheet applications, database applications, slide presentation applications, drawing or computer-aided application programs, artificial intelligence ("AI") applications and machine learning ("ML") modules on cloud-based systems, etc.

Furthermore, examples of the present disclosure may be practiced in an electrical circuit including discrete electronic elements, packaged or integrated electronic chips containing logic gates, a circuit utilizing a microprocessor, or on a single chip containing electronic elements or microprocessors. For example, examples of the present disclosure may be practiced via a system-on-a-chip ("SOC") where each or many of the components illustrated in Fig. 5 may be integrated onto a single integrated circuit. Such an SOC device may include one or more processing units, graphics units, communications units, system virtualization units and various application functionalities all of which may be integrated (or "burned") onto the chip substrate as a single integrated circuit. When operating via an SOC, the functionality, described herein, with respect to generating suggested queries, may be operated via application-specific logic integrated with other components of the computing device 500 on the single integrated circuit (or chip). Examples of the present disclosure may also be practiced using other technologies capable of performing logical operations such as, for example, AND, OR, and NOT, including mechanical, optical, fluidic, and/or quantum technologies.

The computing device 500 may also have one or more input devices 512 such as a keyboard, a mouse, a pen, a sound input device, and/or a touch input device, etc. The output device(s) 514 such as a display, speakers, and/or a printer, etc. may also be included. The aforementioned devices are examples and others may be used. The computing device 500 may include one or more communication connections 516 allowing communications with other computing devices 518. Examples of suitable communication connections 516 include radio frequency ("RF") transmitter, receiver, and/or transceiver circuitry; universal serial bus ("USB"), parallel, and/or serial ports; and/or the like.

The term "computer readable media" as used herein may include computer storage media. Computer storage media may include volatile and nonvolatile, and/or removable and non-removable, media that may be implemented in any method or technology for storage of information, such as computer readable instructions, data structures, or program modules. The system memory 504, the removable storage device 509, and the non-removable storage device 510 are all computer storage media examples (i.e., memory storage). Computer storage media may include random access memory ("RAM"), read-only memory ("ROM"), electrically erasable programmable read-only memory ("EEPROM"), flash memory or other memory technology, compact disk read-only memory ("CD-ROM"), digital versatile disks ("DVD") or other optical storage, magnetic cassettes, magnetic tape, magnetic disk storage or other magnetic storage devices, or any other article of manufacture which can be used to store information and which can be accessed by the computing device 500. Any such computer storage media may be part of the computing device 500. Computer storage media may be non-transitory and tangible, and computer storage media do not include a carrier wave or other propagated data signal.

Communication media may be embodied by computer readable instructions, data structures, program modules, or other data in a modulated data signal, such as a carrier wave or other transport mechanism, and may include any information delivery media. The term "modulated data signal" may describe a signal that has one or more characteristics that are set or changed in such a manner as to encode information in the signal. By way of example, communication media may include wired media such as a wired network or direct-wired connection, and wireless media such as acoustic, RF, infrared, and other wireless media.

In this detailed description, wherever possible, the same reference numbers are used in the drawing and the detailed description to refer to the same or similar elements. In some instances, a sub-label is associated with a reference numeral to denote one of multiple similar components. When reference is made to a reference numeral without specification to an existing sub-label, it is intended to refer to all such multiple similar components. In some cases, for denoting a plurality of components, the suffixes "a" through "n" may be used, where *n* denotes any suitable non-negative integer number (unless it denotes the number 14, if there are components with reference numerals having suffixes "a" through "m" preceding the component with the reference numeral having a suffix "n"), and may be either the same or different from the suffix "n" for other components in the same or different figures. For example, for component #1 X05a-X05n, the integer value of *n* in X05n may be the same or different from the integer value of *n* in X10n for component #2 X10a-X10n, and so on. In other cases, other suffixes (e.g., *s, t, u*, *v, w, x, y,* and/or *z*) may similarly denote non-negative integer numbers that (together with *n* or other like suffixes) may be either all the same as each other, all different from each other, or some combination of same and different (e.g., one set of two or more having the same values with the others having different values, a plurality of sets of two or more having the same value with the others having different values).

An aspect of the invention relates to a system, comprising: a processing system; and memory coupled to the processing system, the memory comprising computer executable instructions that, when executed by the processing system, causes the system to perform virtual platform simulation operations comprising: granting, using a quantum-based scheduler and to each of a plurality of simulated threads during a simulation session, a first quantum of time; receiving, by the quantum-based scheduler and during the granted first quantum of time, a message from each waiting simulated thread among the plurality of simulated threads, the message indicating that the waiting simulated thread is either waiting on an additional quantum grant of time to perform its current assigned simulation task or waiting for an event signal from another simulated thread among the plurality of simulated threads; in response to receiving the message from each waiting simulated thread, decreasing, by the quantum-based scheduler, a counter of active simulated threads based on a number of waiting simulated threads from which corresponding messages are received; and based on a determination that there are no more active simulated threads among the plurality of simulated threads based on the counter of active simulated threads, performing one of: based on a determination that at least one simulated thread is waiting on an additional quantum grant of time to perform its current assigned simulation task, granting, using the quantum-based scheduler and to each of a plurality of simulated threads, a second quantum of time; or based on a determination that each simulated thread in the plurality of simulated threads is waiting on event signals from other simulated threads, ending, using the quantum-based scheduler, the simulation session and performing an end of simulation task.

In some examples, the first quantum of time is one of: a quantum of time that is granted to the plurality of simulated threads at a beginning of the simulation session; or a quantum of time that is granted to the plurality of simulated threads after one or more previous quantum grants of time to the plurality of simulated threads during the simulation session.

In some examples, the simulation session is used to perform at least one of: modelling multi-context system behavior; validating at least one of hardware algorithms, synchronization of the plurality of simulated threads, or system kernels; or finetuning timing from the simulation session to match hardware behavior.

In some examples, at least one simulated thread is actively performing its assigned simulation tasks during an entirety of at least the first quantum of time, wherein the assigned simulation tasks include at least one of time annotation, time simulation, task processing, or assembling instructions for control processors.

In some examples, the event signal includes information of a local simulation time of the simulated thread sending the event signal, wherein the local simulation time is calculated based on a sum of a time corresponding to a preceding quantum grant of time and simulated time spent by the simulated thread sending the event signal up to a moment of sending the event signal.

In some examples, the end of simulation task comprises at least one of: logging a deadlock situation; or tracing, logging, and debugging errors during the simulation session.

In some examples, the virtual platform simulation operations further comprise: using one or more benchmarks to facilitate a match between simulation and hardware conditions; and feeding measurements and metrics from using the one or more benchmarks back into the system to enhance performance of future simulation sessions.

In some examples, the virtual platform simulation operations further comprise: in response to receiving from each active simulated thread among the plurality of simulated threads an indication that an end of the first quantum of time or an end of the second quantum of time has been reached, determining, using the quantum-based scheduler, whether an end of simulation condition has been met, wherein the end of simulation condition includes one of: a determination that the plurality of simulated threads either have completed their assigned simulation tasks or have crashed; or a determination either that no simulated threads are waiting on an additional quantum grant of time or that the plurality of simulated threads are each waiting on an event signal, indicative of a potential deadlock situation having occurred.

In some examples, the virtual platform simulation operations further comprise: for each instance that a quantum of time is granted to the plurality of simulated threads, performing at least one of: synchronizing, using the quantum-based scheduler, simulated time across the plurality of simulated threads; or verifying, using the quantum-based scheduler, a simulated time of each of the plurality of simulated threads.

A second aspect of the invention relates to a computer-implemented method, comprising: receiving, by a quantum-based scheduler and during a first quantum of time that is granted to each of a plurality of threads during a session, a message from each waiting thread among the plurality of threads, wherein the plurality of threads concurrently performs a corresponding plurality of assigned tasks during the first quantum of time, wherein the message indicates that the waiting thread is either waiting on an additional quantum grant of time to perform its current assigned task or waiting for an event from another thread among the plurality of threads; in response to receiving the message from each waiting thread, decreasing, by the quantum-based scheduler, a counter of active threads based on a number of waiting threads from which corresponding messages are received; and based on a determination that there are no more active threads among the plurality of threads based on the counter of active threads, performing one of: based on a determination that at least one thread is waiting on an additional quantum grant of time to perform its current assigned task, granting, using the quantum-based scheduler and to each of a plurality of threads, a second quantum of time; or based on a determination that each thread in the plurality of threads is waiting on events from other threads, ending, using the quantum-based scheduler, the session and performing an end of task.

In some examples, the end of task comprises at least one of: logging a deadlock situation; or tracing, logging, and debugging errors during the session.

In some examples, the quantum-based scheduler is part of a virtual platform system, which also includes a processor executing the plurality of threads, wherein the first quantum of time and the second quantum of time are one of: selected to be the same value, based on a balance between precision of annotation and performance of the virtual platform system; or dynamically selected based on measurements of how often the plurality of threads have been signaling each other during a previous quantum of time.

In some examples, the method further comprises each time that a quantum of time is granted to the plurality of threads, performing at least one of: synchronizing, using the quantum-based scheduler, time across the plurality of threads; or verifying, using the quantum-based scheduler, a time of each of the plurality of threads.

In some examples, verifying the time of each of the plurality of threads is performed based on time stamps of events that are signaled to the threads.

In some examples, the method further comprises in response to receiving from each active thread among the plurality of threads that an end of the first quantum of time or an end of the second quantum of time has been reached, determining, using the quantum-based scheduler, whether an end condition has been met, wherein the end condition includes one of: a determination that the plurality of threads either have completed their assigned tasks or have crashed; or a determination either that no threads are waiting on an additional quantum grant of time or that the plurality of threads are each waiting on an event signal, indicative of a potential deadlock situation having occurred.

A third aspect of the invention relates to a virtual platform simulator system, comprising: a quantum-based scheduler; and a plurality of simulated threads that are concurrently executed by a processor, each simulated thread being configured to perform operations comprising: given a quantum grant of simulated time, determining whether an event signal has been received from another simulated thread among the plurality of simulated threads; and performing one of: based on a determination that an event signal has not been received from another simulated thread, waiting for an event signal from another simulated thread and reporting to the quantum-based scheduler either to indicate that it is waiting on an event signal to perform current assigned simulation tasks or to indicate to decrement a counter of active threads; or based on a determination that an event signal has been received from another simulated thread, determining whether a remainder of the quantum grant of simulated time is sufficient to complete its current assigned simulation task, and performing one of: based on a determination that a remainder of the quantum grant of simulated time is sufficient to complete its current assigned simulation task, performing currently assigned simulation tasks; based on a determination that a remainder of the quantum grant of simulated time is insufficient to complete its current assigned simulation task, waiting on an additional quantum grant of time to perform its current assigned simulation task and reporting to the quantum-based scheduler either to indicate that it is waiting on an additional quantum grant of time to perform its current assigned simulation task or to indicate to decrement a counter of active threads; or based on a determination that a remainder of the quantum grant of simulated time is insufficient to complete its current assigned simulation task, performing currently assigned simulation tasks until the quantum grant of simulated time has ended, waiting on an additional quantum grant of time to continue performing its current assigned simulation task, and reporting to the quantum-based scheduler either to indicate that it is waiting on an additional quantum grant of time to continue performing its current assigned simulation task or to indicate to decrement a counter of active threads.

In some examples, the assigned simulation tasks include at least one of time annotation, time simulation, task processing, or assembling instructions for control processors.

In some examples, the operations further comprise: in response to receiving the additional quantum grant of time, performing or continuing to perform its current assigned simulation task, and reporting to the quantum-based scheduler either to indicate that it is resuming processing or to indicate to increase the counter of active threads.

In some examples, the event signal includes information of a sender simulation time of the simulated thread sending the event signal, wherein the local simulation time is calculated based on a sum of a time corresponding to a preceding quantum grant of time and simulated time spent by the simulated thread sending the event signal up to a moment of sending the event signal.

In some examples, the operations further comprise one of: based on a determination that the sender simulation time that is received in the event signal is at or later than its local simulation time, reconstructing its local simulation time based on the local simulation time that is received in the event signal from the simulated thread sending the event signal; or based on a determination that the sender simulation time that is received in the event signal is before its local simulation time, ignoring the sender simulation time.

In another aspect the invention relates to systems and methods for implementing efficient multithreaded quantum-based scheduler with time simulation. In response to a virtual platform simulator using a quantum-based scheduler to grant a first quantum of time to each of a plurality of simulated threads during a simulation session, each simulated thread reports its waiting status (e.g., waiting for additional quantum grants of time or waiting for an event signal from another simulated thread) to the quantum-based scheduler, at a sub-quantum level. The quantum-based scheduler is thus kept updated on a sub-quantum level, and thus is able to keep a sub-quantum count of active simulated threads as well as a sub-quantum count of simulated threads waiting for additional quantum grants of time and/or a sub-quantum count of simulated threads waiting for event signals. The quantum-based scheduler may also enable automatic detection of potential deadlock conditions (e.g., where each simulated thread is waiting for event signals).

Unless otherwise indicated, all numbers used herein to express quantities, dimensions, and so forth used should be understood as being modified in all instances by the term "about." In this application, the use of the singular includes the plural unless specifically stated otherwise, and use of the terms "and" and "or" means "and/or" unless otherwise indicated. Moreover, the use of the term "including," as well as other forms, such as "includes" and "included," should be considered non-exclusive. Also, terms such as "element" or "component" encompass both elements and components including one unit and elements and components that include more than one unit, unless specifically stated otherwise.

In this detailed description, for the purposes of explanation, numerous specific details are set forth to provide a thorough understanding of the described embodiments. It will be apparent to one skilled in the art, however, that other embodiments of the present invention may be practiced without some of these specific details. In other instances, certain structures and devices are shown in block diagram form. While aspects of the technology may be described, modifications, adaptations, and other implementations are possible. For example, substitutions, additions, or modifications may be made to the elements illustrated in the drawings, and the methods described herein may be modified by substituting, reordering, or adding stages to the disclosed methods. Accordingly, the detailed description does not limit the technology, but instead, the proper scope of the technology is defined by the appended claims. Examples may take the form of a hardware implementation, or an entirely software implementation, or an implementation combining software and hardware aspects. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features. The detailed description is, therefore, not to be taken in a limiting sense.

Aspects of the present invention, for example, are described above with reference to block diagrams and/or operational illustrations of methods, systems, and computer program products according to aspects of the invention. The functions and/or acts noted in the blocks may occur out of the order as shown in any flowchart. For example, two blocks shown in succession may in fact be executed substantially concurrently or the blocks may sometimes be executed in the reverse order, depending upon the functionalities and/or acts involved. Further, as used herein and in the claims, the phrase "at least one of element A, element B, or element C" (or any suitable number of elements) is intended to convey any of: element A, element B, element C, elements A and B, elements A and C, elements B and C, and/or elements A, B, and C (and so on).

The description and illustration of one or more aspects provided in this application are not intended to limit or restrict the scope of the invention as claimed in any way. The aspects, examples, and details provided in this application are considered sufficient to convey possession and enable others to make and use the best mode of the claimed invention. The claimed invention should not be construed as being limited to any aspect, example, or detail provided in this application. Regardless of whether shown and described in combination or separately, the various features (both structural and methodological) are intended to be selectively rearranged, included, or omitted to produce an example or embodiment with a particular set of features. Having been provided with the description and illustration of the present application, one skilled in the art may envision variations, modifications, and alternate aspects, examples, and/or similar embodiments falling within the broader aspects of the general inventive concept embodied in this application that do not depart from the broader scope of the claimed invention.

## Claims

1. A system (100), comprising:
a processing system (502); and
memory (504) coupled to the processing system, the memory comprising computer executable instructions that, when executed by the processing system, causes the system to perform virtual platform simulation operations comprising:
granting (402), using a quantum-based scheduler and to each of a plurality of simulated threads during a simulation session, a first quantum of time;
receiving (404), by the quantum-based scheduler and during the granted first quantum of time, a message from each waiting simulated thread among the plurality of simulated threads, the message indicating that the waiting simulated thread is either waiting on an additional quantum grant of time to perform its current assigned simulation task or waiting for an event signal from another simulated thread among the plurality of simulated threads;
in response to receiving the message from each waiting simulated thread, decreasing (406), by the quantum-based scheduler, a counter of active simulated threads based on a number of waiting simulated threads from which corresponding messages are received; and
based on a determination (408) that there are no more active simulated threads among the plurality of simulated threads based on the counter of active simulated threads, performing one of:
based on a determination (410) that at least one simulated thread is waiting on an additional quantum grant of time to perform its current assigned simulation task, granting, using the quantum-based scheduler and to each of a plurality of simulated threads, a second quantum of time; or
based on a determination (418) that each simulated thread in the plurality of simulated threads is waiting on event signals from other simulated threads, ending, using the quantum-based scheduler, the simulation session and performing an end of simulation task.

2. The system of claim 1, wherein the first quantum of time is one of:
a quantum of time that is granted to the plurality of simulated threads at a beginning of the simulation session; or
a quantum of time that is granted to the plurality of simulated threads after one or more previous quantum grants of time to the plurality of simulated threads during the simulation session.

3. The system of claim 1 or claim 2, wherein the simulation session is used to perform at least one of:
modelling multi-context system behavior;
validating at least one of hardware algorithms, synchronization of the plurality of simulated threads, or system kernels; or
finetuning timing from the simulation session to match hardware behavior.

4. The system of any of claims 1 to 3, wherein at least one simulated thread is actively performing its assigned simulation tasks during an entirety of at least the first quantum of time, wherein the assigned simulation tasks include at least one of time annotation, time simulation, task processing, or assembling instructions for control processors.

5. The system of any of claims 1 to 4, wherein the event signal includes information of a local simulation time of the simulated thread sending the event signal, wherein the local simulation time is calculated based on a sum of a time corresponding to a preceding quantum grant of time and simulated time spent by the simulated thread sending the event signal up to a moment of sending the event signal.

6. The system of any of claims 1 to 5, wherein the end of simulation task comprises at least one of:
logging a deadlock situation; or
tracing, logging, and debugging errors during the simulation session.

7. The system of any of claims 1 to 6, wherein the virtual platform simulation operations further comprise:
using one or more benchmarks to facilitate a match between simulation and hardware conditions; and
feeding measurements and metrics from using the one or more benchmarks back into the system to enhance performance of future simulation sessions.

8. The system of any of claims 1 to 7, wherein the virtual platform simulation operations further comprise:
in response to receiving from each active simulated thread among the plurality of simulated threads an indication that an end of the first quantum of time or an end of the second quantum of time has been reached, determining, using the quantum-based scheduler, whether an end of simulation condition has been met, wherein the end of simulation condition includes one of:
a determination that the plurality of simulated threads either have completed their assigned simulation tasks or have crashed; or
a determination either that no simulated threads are waiting on an additional quantum grant of time or that the plurality of simulated threads are each waiting on an event signal, indicative of a potential deadlock situation having occurred.

9. The system of any of claims 1 to 8, wherein the virtual platform simulation operations further comprise:
for each instance that a quantum of time is granted to the plurality of simulated threads, performing at least one of:
synchronizing, using the quantum-based scheduler, simulated time across the plurality of simulated threads; or
verifying, using the quantum-based scheduler, a simulated time of each of the plurality of simulated threads.

10. A computer-implemented method (400), comprising:
receiving (404), by a quantum-based scheduler and during a first quantum of time that is granted to each of a plurality of threads during a session, a message from each waiting thread among the plurality of threads, wherein the plurality of threads concurrently performs a corresponding plurality of assigned tasks during the first quantum of time, wherein the message indicates that the waiting thread is either waiting on an additional quantum grant of time to perform its current assigned task or waiting for an event from another thread among the plurality of threads;
in response to receiving the message from each waiting thread, decreasing (406), by the quantum-based scheduler, a counter of active threads based on a number of waiting threads from which corresponding messages are received; and
based on a determination (408) that there are no more active threads among the plurality of threads based on the counter of active threads, performing one of:
based on a determination (410) that at least one thread is waiting on an additional quantum grant of time to perform its current assigned task, granting, using the quantum-based scheduler and to each of a plurality of threads, a second quantum of time; or
based on a determination (418) that each thread in the plurality of threads is waiting on events from other threads, ending, using the quantum-based scheduler, the session and performing an end of task.

11. The computer-implemented method of claim 10, wherein the end of task comprises at least one of:
logging a deadlock situation; or
tracing, logging, and debugging errors during the session.

12. The computer-implemented method of claim 10 or claim 11, wherein the quantum-based scheduler is part of a virtual platform system, which also includes a processor executing the plurality of threads, wherein the first quantum of time and the second quantum of time are one of:
selected to be the same value, based on a balance between precision of annotation and performance of the virtual platform system; or
dynamically selected based on measurements of how often the plurality of threads have been signaling each other during a previous quantum of time.

13. The computer-implemented method of any of claims 10 to 12, further comprising:
each time that a quantum of time is granted to the plurality of threads, performing at least one of:
synchronizing, using the quantum-based scheduler, time across the plurality of threads; or
verifying, using the quantum-based scheduler, a time of each of the plurality of threads.

14. The computer-implemented method of claim 13, wherein verifying the time of each of the plurality of threads is performed based on time stamps of events that are signaled to the threads.

15. A virtual platform simulator system (135), comprising:
a quantum-based scheduler (140); and
a plurality of simulated threads (145) that are concurrently executed by a processor (110), each simulated thread being configured to perform operations comprising:
given a quantum grant of simulated time, determining (452) whether an event signal has been received from another simulated thread among the plurality of simulated threads; and
performing one of:
based on a determination that an event signal has not been received from another simulated thread, waiting (454) for an event signal from another simulated thread and reporting to the quantum-based scheduler either to indicate that it is waiting on an event signal to perform current assigned simulation tasks or to indicate to decrement a counter of active threads; or
based on a determination that an event signal has been received from another simulated thread, determining (456) whether a remainder of the quantum grant of simulated time is sufficient to complete its current assigned simulation task, and performing one of:
based on a determination that a remainder of the quantum grant of simulated time is sufficient to complete its current assigned simulation task, performing (458) currently assigned simulation tasks;
based on a determination that a remainder of the quantum grant of simulated time is insufficient to complete its current assigned simulation task, waiting (460) on an additional quantum grant of time to perform its current assigned simulation task and reporting to the quantum-based scheduler either to indicate that it is waiting on an additional quantum grant of time to perform its current assigned simulation task or to indicate to decrement a counter of active threads; or
based on a determination that a remainder of the quantum grant of simulated time is insufficient to complete its current assigned simulation task, performing currently assigned simulation tasks until the quantum grant of simulated time has ended, waiting on an additional quantum grant of time to continue performing its current assigned simulation task, and reporting to the quantum-based scheduler either to indicate that it is waiting on an additional quantum grant of time to continue performing its current assigned simulation task or to indicate to decrement a counter of active threads.
